Europäisches Patentamt

European Patent Office

Office européen des brevets

(11) Publication number: 0 244 071
A1

# EUROPEAN PATENT APPLICATION

(21) Application number: 87302207.3

(51) Int. Cl.⁴: **G01R 23/16**

(22) Date of filing: **16.03.87**

(30) Priority: **23.04.86 GB 8609857**

(43) Date of publication of application:
**04.11.87 Bulletin 87/45**

(84) Designated Contracting States:
**BE DE FR IT NL**

(71) Applicant: **STC PLC**
**10, Maltravers Street**
**London, WC2R 3HA(GB)**

(72) Inventor: **Jeffries, Andrew William**
**9 Goldings**
**Bishop's Stortford Hertfordshire CM23**
**5E(GB)**

(54) **RF spectrum analysing receiver.**

(57) An RF spectrum analysing receiver comprising front end RF filtering and amplifying stages (I,2) for incoming signals, local oscillator generating means (4) and mixing means (3) whereby the incoming signals are mixed down to either zero IF or low IF frequency, digitising means (6) to which the mixed down signals are applied, and discrete Fourier transform means (7) to which the digitised signals are applied to perform a frequency spectrum analysis of the signals.

Fig.1.

EP 0 244 071 A1

## RF SPECTRUM ANALYSING RECEIVER

This invention relates to a receiver having the capability to analyse RF signals over band of frequencies.

In order to obtain a spectral measurement of incoming signals, e.g. for signal identification purposes prior to demodulations it is necessary to have a high resolution so that, for example, the centre frequency of an incoming signal can be found quickly. Conventional signal measuring equipments in service at present are either entirely manual or semi-automatic, using sequential switched narrow filters to discriminate individual signals and monitor the received power. Typical performance for a superhet receiver is, for an analogue system, very good but slow. Its sensitivity is excellent and resolution limited only by the IF filter performance. The scan time required by a superhet is at best approximately $B/C^2$ where B = system bandwidth and C = channel bandwidth. All that can be done in this time is to ascertain the occupancy or otherwise of each channel, i.e. only carrier information is available and further dwell time must be allowed for modulation details to be obtained. This analysis procedure is slow and ponderous.

The object of the present invention is to minimise or to overcome this disadvantage.

According to the present invention there is provided an RF spectrum analysing receiver, including means for performing a fast Fourier transform (FFT) on a received signal, characterised in that means are provided for coupling said transform for a plurality of input points from a reduced number of output points.

According to the present invention there is further provided an RF spectrum analysing receiver comprising front end RF filtering and amplifying stages for incoming signals, local oscillator generating means and mixing means whereby the incoming signals are mixed down to either zero IF or low IF frequency, digitising means having N inputs to which the mixed down signals are applied, and discrete Fourier transform means to which the digitised signals are applied to perform a frequency spectrum analysis of the signals, characterised in that the discrete Fourier transform means implements a fast Fourier transform (FFT) algorithm with selective partitioning to allow computation of a total of $\frac{N}{2}$ output points.

Embodiments of the invention will now be described with reference to the accompanying drawings, in which:-

Fig. 1 is a block diagram of an RF spectrum analysing receiver utilising a discrete Fourier transform,

Figs. 2(a) and 2(b) depict various filter response characteristics.

Fig. 3 depicts an implementation for a decimation-in-time algorithm, and

Fig. 4 depicts an implementation for a decimation-in-frequency algorithm.

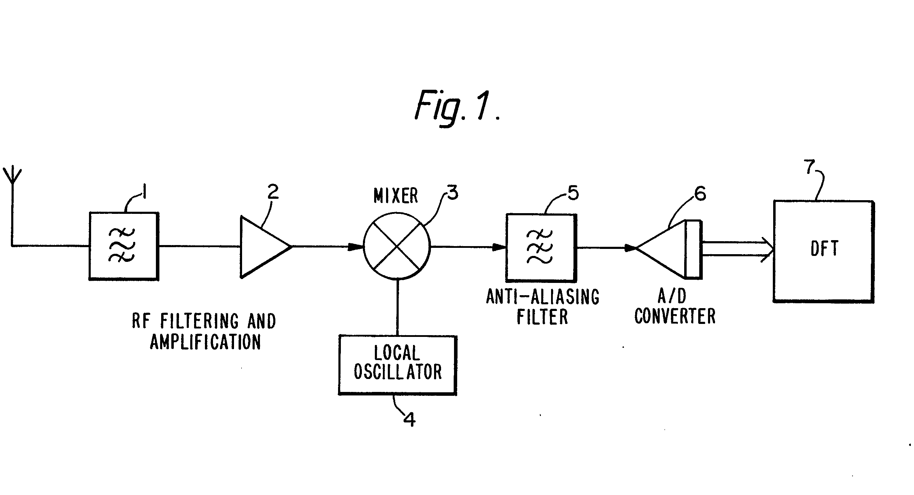

In the arrangement shown in Fig. 1 an RF spectrum analysing receiver comprises a front end RF filter 1 followed by an amplifier 2. The signals are then mixed 3 with signal from a local oscillator 4 to bring the incoming signals down to either zero I.F. or a low I.F. after which the signals pass through an anti-aliasing filter 5 to a digitising stage 6. The filtering up to this point may be minimal, merely protecting the RF circuitry from unwanted signals and preventing aliasing by the digitising process. After digitising the effects of imperfections in the data caused by analogue errors, e.g. d.c. effects, phase and amplitude effects may be reduced by conditioning. The digitised signals are then applied to a discrete Fourier transform stage 7 which achieves the equivalent of a bank of equally-spaced identical filters.

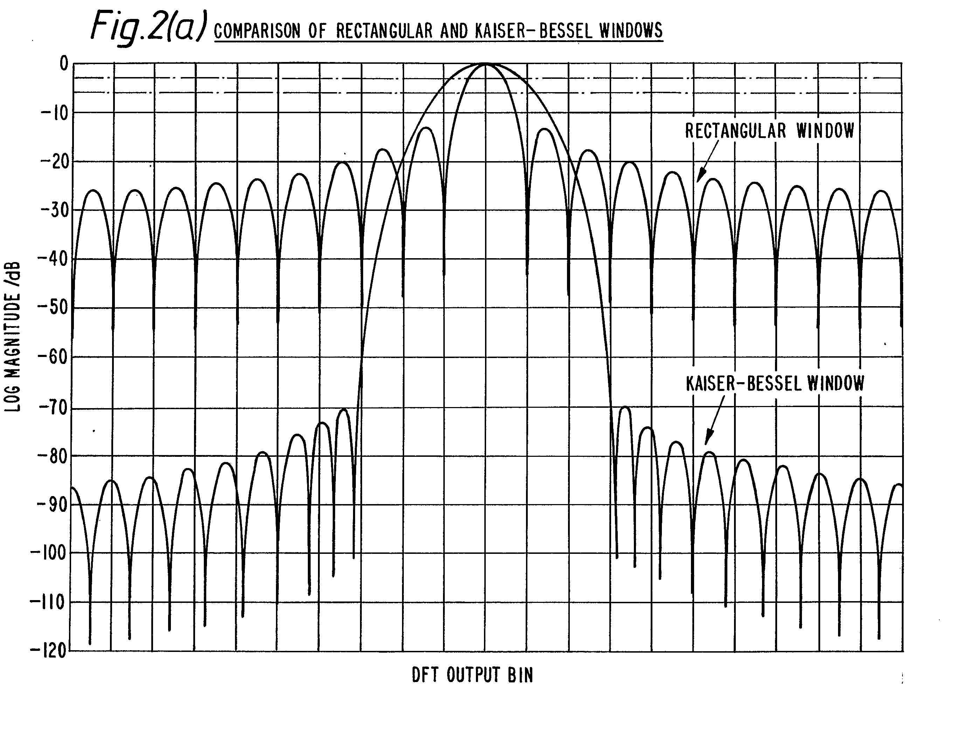

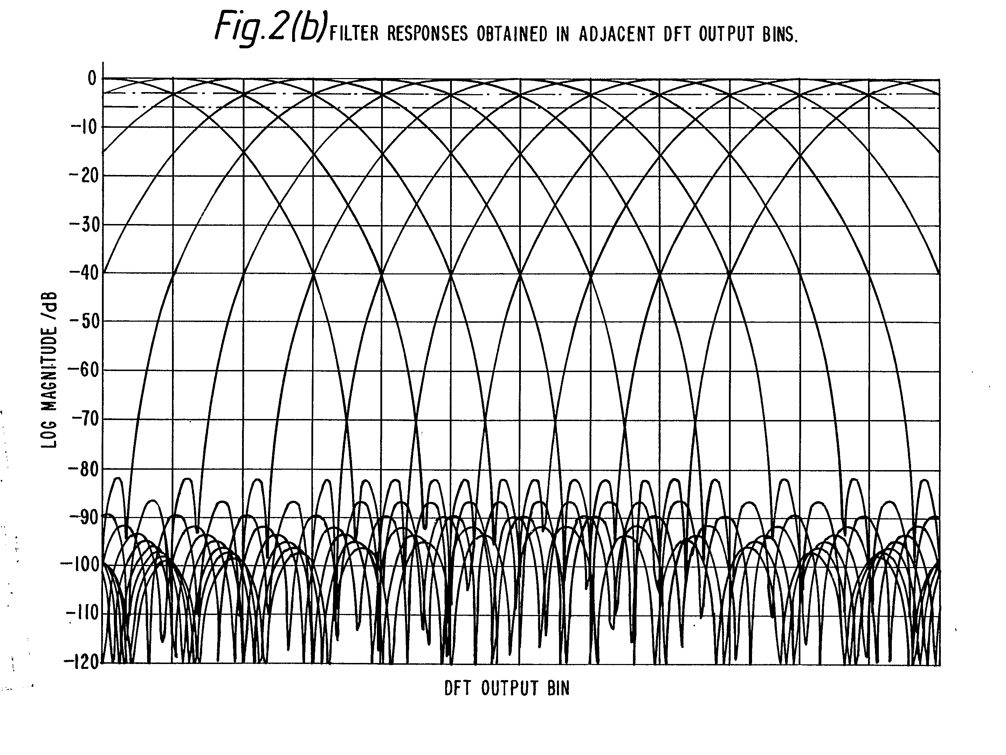

The filter response in the discrete Fourier transform is dictated by the taper applied to the input data (termed 'the window'). Windows are used in spectral analysis to reduce the effects of spectral leakage caused by the process of examination of a finite data set. If a signal is not periodic within the observation interval then there are discontinuities at the boundaries of the interval which result in spectral leakage over the entire frequency range. Windows reduce the spectral leakage by tailoring the input data set by multiplication to reduce as many orders of derivative of the discontinuity at the boundary as possible. A rectangular window, i.e. sampling with effectively no tapering, results in a sinc (x) filter response centred around each of the discrete Fourier transform output points as shown in Figure 2(a). The high sidelobe levels are undesirable for signal identification, since nearby small signals can be swamped by larger signals. Sidelobe levels can be reduced by applying windows to the transform input data, thus improving the dynamic range of such an analysis system, but this is at the expense of a broadening in the main filter lobe as shown in Figure 2(a), where a typical Kaiser-Bessel window function is shown. This increase in filter bandwidth across several transform output bias requires a larger number of points in the transform to cover a fixed band to the same resolution, and thus increases the amount of processing required.

Each transform output bin has a filter response dictated by the windowing function as shown in figure 2-(a). Figure 2(b) shows the bank of adjacent filter responses obtained with a discrete Fourier transform and the points at which adjacent filter responses intersect in Figure 2(b) determine the reduction in sensitivity for a signal half way between two filters. and is termed the scalloping loss. This loss is window dependent and for most commonly used window functions with sidelobes more than 50 dB down, is of the order of 1 dB. Two known window functions which are considered useful and apparently optimum for spectral analysis are the Kaiser-Bessel and the Blackman-Harris windows. The windows shape $W(\omega)$ (filter frequency response) is important since it will dictate the overall signal detection performance of the receiver.

The choice of filter response depends upon application, for example if phase linearity across the passband is necessary (e.g. for data reception), a different filter would be required than if purely resolution (filter roll off) were important. In the case of signal detection addressed by the discrete Fourier transform there are basically three parameters that should be considered:

(i) resolution

(ii) scalloping loss

(iii) sidelobe level (spectral leakage bias).

(i) Resolution

One criterion in the detection of tones is the ability to resolve two or more closely spaced spectral lines. The classic criterion for this is the width of the window at the half-power points (the 3 dB bandwidth). This is not the case for the coherent addition found in the discrete Fourier transform, where if two kernels are contributing to the coherent summation the sum at the crossover point must be smaller than the individual peaks if the two peaks are to be resolved. Thus at the crossover points of the kernels, the gains must be less than 0.5 i.e. beyond the 6 dB points. Unfortunately, this results in large scalloping losses, and it is required to assess the tradeoffs for the requirement.

(ii) Scalloping Loss

This refers to the decrease in detected signal amplitude when the input frequency is not an integer submultiple of the sampling frequency as is shown in Figure 2(b). The loss is greatest halfway between the peaks of adjacent filters at the points where the filter responses intersect, and is defined by the equation:

$$\text{Scalloping loss} \qquad \frac{\left| W\left(\frac{1}{2} \frac{\omega_s}{N}\right) \right|}{W(0)}$$

where $\omega_s$ is the sampling frequency, N the number of points of the DFT.

The consequence of this is that the signal to noise, and sensitivity of the detection system is dependent upon the input frequency. This is undesirable, but the tolerable level will depend upon the desired dynamic range of detectable signals, and the sidelobe levels of the filters used.

(iii) Sidelobe Level

For multiple-tone detection of signals via the discrete Fourier transform, the window used has a considerable effect. In order to detect small signals in the presence of larger ones, it is essential that the window has a highly concentrated central lobe with a very low sidelobe structure to prevent the sidelobes of the larger signal completely swamping the main lobe of the smaller signal. Another effect of this 'spectral leakage' is that a large signal can cause a bias in the amplitude and the position of a harmonic estimate of a smaller signal. It is for this reason that both sidelobe level and fall off are important.

If a larger scalloping loss is acceptable, which is the case for some spectral analysis problems, it is possible to use alternate transform output points; this can increase scalloping losses by 3 dB or more depending upon window, but can significantly reduce the amount of processing required to compute the transform, since only half of the output points are required.

3

The number of points required in a discrete Fourier transform is dictated by the sampling frequency filter bandwidth required, and the window shape. For a requirement when an increased scalloping loss is acceptable, it is possible to compute an N input point transform with $\frac{N}{2}$ output points. In general, by accepting an increased scalloping loss, it is possible to compute an N input point transform with fewer than N output points. This considerably reduces the number of computations required and thus increases the signal processing speed.

There are many algorithms that have been developed to compute discrete Fourier transforms efficiently. However, currently, the Radix 2 fast Fourier transform (FFT) algorithm is most popular due to its regular hardware architecture. The FFT algorithm used to decompose the discrete Fourier transform proves to be ideal for allowing the computation of only $\frac{N}{2}$ output points efficiently.

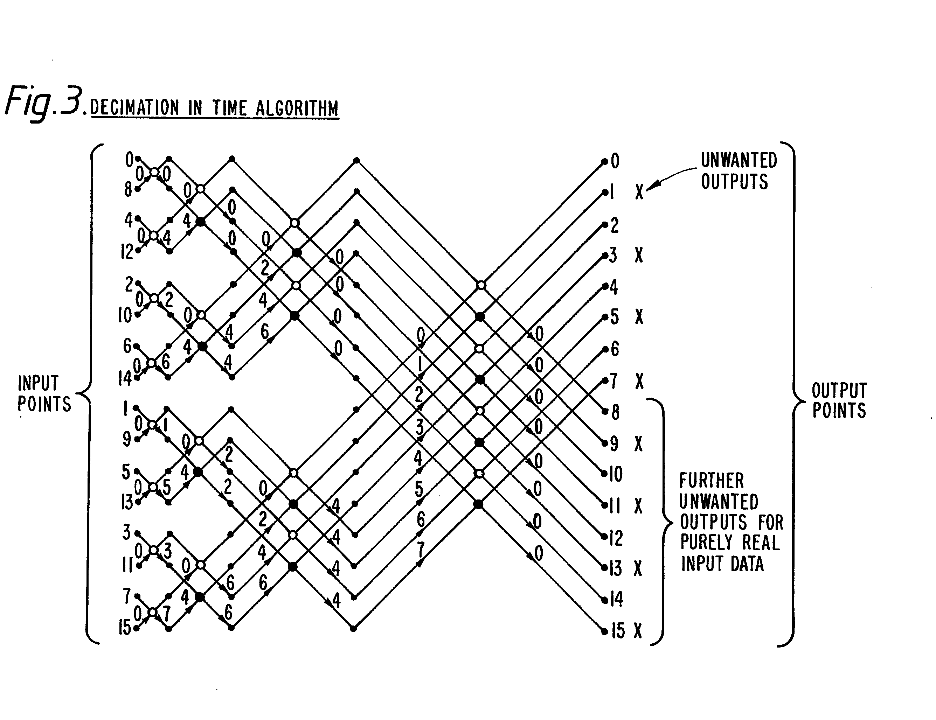

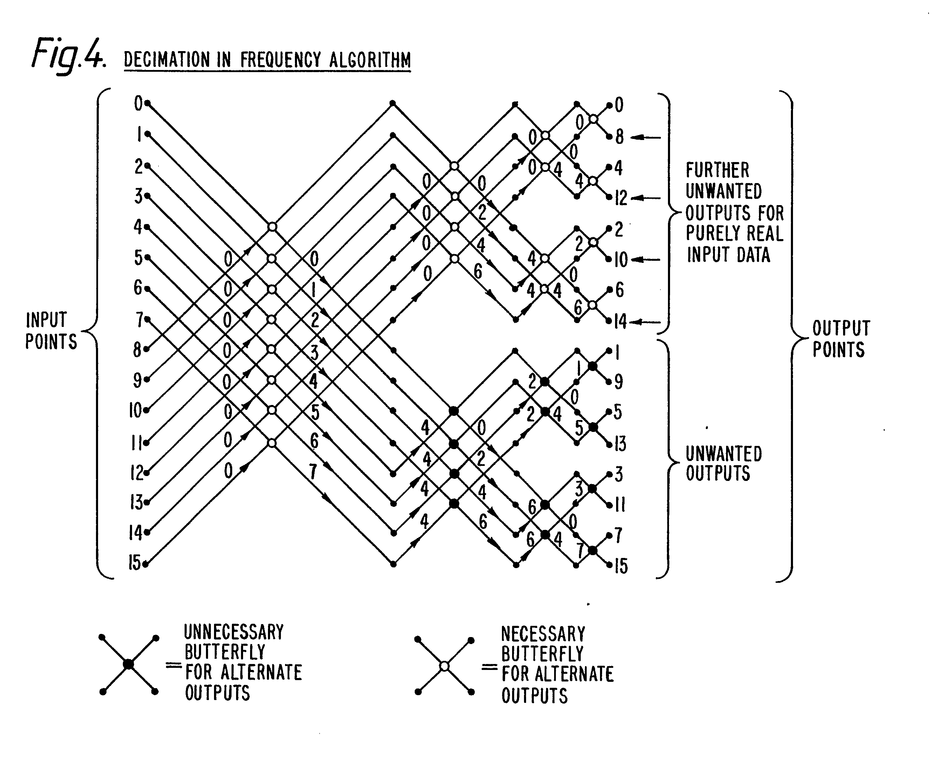

The FFT algorithm developed by Cooley and Tukey (Math. Computing Vol. 19 pp297-301, April 1965) involves partitioning the input sequence into two parts, and reducing the original into two discrete Fourier transforms (DFT) of half the original size. There are two alternative methods of partitioning the input sequence resulting in the decimation in frequency (DIF) and decimation in time (DIT) algorithms. Implementations of these are shown in Fig. 3 and Fig. 4 respectively.

The DIT algorithm partitions the input sequence into even and odd points, and the DFT equation then becomes

$$X(k) = \sum_{n=0}^{N-1} x(n)W_N^{nk} + \sum_{n=1}^{N-1} x(n)W_N^{nk}$$

n even                 n odd

n=2r                   n=2r+1     r=0,1,...N/2-1

$$= \sum_{r=0}^{N/2-1} x(2r)W_N^{2rk} + \sum_{r=0}^{N/2-1} x(2r+1)W_N^{(2r+1)k}$$

however,

$$W_N^2 = \exp(-j(2\pi/N.2)) = \exp(-j2\pi/(N/2)) = W_{N/2}$$

so

$$X(k) = \sum_{r=0}^{N/2-1} x(2r)\, W_{N/2}^{rk} + W_N^k \sum_{r=0}^{N/2-1} x(2r+1)\, W_{N/2}^{rk} \qquad \ldots (1)$$

This has decomposed the original N-point DFT into 2 N/2 point DFTs performed upon the odd and even points of the original sequence.

This can be rewritten in the form:

$$X(k) = G(k) + W_N^k\, H(k)$$

where G(k) and H(k) are the N/2 point DFTs of g(n) and h(n), the odd and even points of the original sequence. Since X(k) is defined for $0 \le k \le N-1$ and G(k) and H(k) are defined for $0 \le k \le N/2-1$ then equation (l) should be interpreted as:

$$X(k) = G(k) + W_N^k H(k) \qquad 0 \le k \le N/2-1$$
$$= G(k-N/2) + W_N^k H(k-N/2) \qquad N/2 \le k \le kN-l \quad \ldots (2)$$

If $N = 2^M$ then the DFTs can be continually sub-divided until the DFT is ultimately decomposed into N/2 2-point DFTs. This basic operation of the DIT algorithm is termed a bufferfly. If the inputs are A and B, then the radix 2 DIT butterfly combines these to give two outputs X and Y via the equation

$$X = A + W_N^k B$$

$$Y = A - W_N^k B$$

This is depicted in Fig. 3 for a l6-point FFT.

The DIF algorithm partitions the input sequence by considering the first and second blocks of N/2 points. The DFT equation then becomes:

$$X(k) = \sum_{n=0}^{N/2-1} x(n) W_N^{nk} + \sum_{n=N/2}^{N-1} x(n) W_N^{nk}$$

this can be reduced to:

$$X(k) = \sum_{n=0}^{N/2-1} [x(n) + W_N^{Nk/2} x(n+N/2)] W_N^{nk} \qquad \ldots (3)$$

If one considers the odd and even members of a particular DFT, noting that a 2-point DFT would consist of l even and l odd point:-

For even points:

$$X(2k) = \sum_{n=0}^{N/2-1} [x(n) + x(n+N/2)] W_{N/2}^{nk} \qquad \ldots (4)$$

For odd points:

$$X(2k+1) = \sum_{n=0}^{N/2-1} [x(n) - x(n+N/2)] W_N^{n} \cdot W_{N/2}^{kn} \qquad \ldots (5)$$

Equations (4) and (5) show that the even and odd samples of the DFT can be obtained from the N/2-point DFTs of the sequences. Furthermore if, as before, this division is continued to the limit of 2-point DFTs, then the basic computational unit, the radix 2 DIF butterfly, performs the operation

$$X = A + B$$

$$Y = (A - B) W_N^k$$

This is depicted in Fig. 4 for a l6-point FFT.

The decimation in time and decimation in frequency FFT algorithms are of use when the number of points is a power of 2 in which case the algorithm is called a radix 2 algorithm. Similarly, if N is a power of 4 then a radix 2 or radix 4 algorithm could be used.

The advantage of the FFT DIT and DIF algorithm is that they can be performed 'in place' i.e. no extra memory locations are required when the FFT is being performed since intermediate calculations can he stored in the locations of the original source data. For larger transforms this is quite an important consideration.

Another advantage of the FFT is that operations upon complex input numbers can be performed at minimal extra processing or hardware cost since the $W_N^k$ are complex vectors, intermediate calculations must be stored as complex numbers and the intermediate calculations of the FFT involve complex members anyway.

The number of multiplications required for an N-point DFT is reduced from $N^2$ to $(N/2)\log_2 N$ (including trivial multiplications) by these algorithms which constitutes a considerable saving as the transform size is increased.

Owing to the mechanism of partitioning used in the derivation of the FFT algorithm, it is demonstrated in Figures 3 and 4 that, if only alternate output points are required, with either the decimation in time or decimation in frequency algorithms, the full number of butterflies is only necessary on the first pass, subsequent passes require only half of the butteflies. Thus, for an N-point FFT, where $N = 2^M$, the number of butterflies required is:

$$B = \frac{N}{4}(M + 1)$$

or

$$B = \frac{N}{4}(1 + \log_2 N) \quad \dots (6)$$

This does not include a pass for windowing, however here the structure of the butterfly can reduce the computational requirement again. The basic decimation in time butterfly calculation is:

$$X = A + BW_N^k$$

$$Y = A - BW_N^k$$

$W_N^k$ operates upon all the odd points of the input during the first pass of the FFT, and so the weighting coefficients for these points can be included within $W_N^k$, leaving only the even points of the input requiring weighting multiplications.

The Radix 2 FFT algorithm is very attractive owing to the simple hardware structure.

The butterfly time necessary for the Radix 2 FFT algorithm used for signal detection in the receiver can be expressed as

$$T_{BUTT} = \frac{4.OVR}{(1+\log_2 N)} \cdot \frac{1}{S} \tag{5.5.9}$$

where OVR = overlap ($\frac{1}{2}$ = 50 percent overlap

and  N = FFT size

S = the sampling rate (complex input)

## Claims

1. An RF spectrum analysing receiver, including means for performing a fast Fourier transform (FFT) on a received signal, characterised in that means are provided for coupling said transform for a plurality of input points from a reduced number of output points.

2. An RF spectrum analysing receiver comprising front end RF filtering and amplifying stages for incoming signals, local oscillator generating means and mixing means whereby the incoming signals are mixed down to either zero IF or low IF frequency, digitising means having N inputs to which the mixed down signals are applied. and discrete Fourier transform means to which the digitised signals are applied to perform a frequency spectrum analysis of the signals, characterised in that the discrete Fourier transform means implements a fast Fourier transform (FFT) algorithm with selective partitioning to allow computation of a total of $\frac{N}{2}$ output points.

3. A receiver according to claim 2 characterised in that the sequence of input points is partitioned into two groups of even numbered and odd numbered points respectively and computation according to the Radix 2 fast Fourier transform is effected initially on pairs of input points in each groups and subsequent computation operations are performed on selected pairs of outputs of previous computations.

4. A receiver according to claim 2 characterised in that the sequence of input points is partitioned into two groups being the first N/2 points and the second N/2 points respectively and computation according to the Radix 2 fast Fourier transform is effected initially on pairs of input points, each pair being corresponding points from each group and subsequent computation operations are performed on selected pairs of outputs of previous computations.

5. A method of spectrum analysing RF signals including the steps of mixing the signals down to either zero IF or low IF, digitising the signals and performing a fast Fourier transform (FFT) on the digitised signals characterised in that selective partitioning of N input points is effected to allow computation of a total of $\frac{N}{2}$ output points.

Fig. 1.

RF FILTERING AND AMPLIFICATION — MIXER — ANTI-ALIASING FILTER — A/D CONVERTER — DFT — LOCAL OSCILLATOR

0 244 071

*Fig.2(a)* COMPARISON OF RECTANGULAR AND KAISER-BESSEL WINDOWS

RECTANGULAR WINDOW

KAISER-BESSEL WINDOW

LOG MAGNITUDE /dB

DFT OUTPUT BIN

0 244 071

*Fig.2(b)* FILTER RESPONSES OBTAINED IN ADJACENT DFT OUTPUT BINS.

0 244 071

**Fig.3.** <u>DECIMATION IN TIME ALGORITHM</u>

INPUT POINTS

OUTPUT POINTS

UNWANTED OUTPUTS

FURTHER UNWANTED OUTPUTS FOR PURELY REAL INPUT DATA

0 244 071

Fig.4. DECIMATION IN FREQUENCY ALGORITHM

INPUT POINTS

OUTPUT POINTS

FURTHER UNWANTED OUTPUTS FOR PURELY REAL INPUT DATA

UNWANTED OUTPUTS

= UNNECESSARY BUTTERFLY FOR ALTERNATE OUTPUTS

= NECESSARY BUTTERFLY FOR ALTERNATE OUTPUTS

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | ELECTRONIC DESIGN, vol. 30, no. 17, 19th August 1982, pages 149-154, Waseca, GB; S. MAGAR et al.: "Signal-processing muC builds FFT-based spectrum analyzer" * Page 149, column 1, line 13 - column 2, line 11; page 152, column 1, line 1 - page 153, column 2, line 28 * | 1 | G 01 R 23/16 |
| A | FR-A-2 536 541 (LABORATOIRE CENTRAL DE TELECOMMUNICATIONS) * Page 1, lines 21-33 * | 1 | |
| A | TECHNICAL REVIEW, no. 2, 1980, pages 3-44, Naerum, DK; N. THRANE: "Zoom-FFT" * Page 4, line 1 - page 14, line 2; figures 4-6 * | 1,5 | |
| A | IEEE TRANSACTIONS ON COMPUTERS, vol. C-19, no. 11, November 1970, pages 1015-1019, New York, US; H.L. GROGINSKY et al.: "A pipeline fast fourier transform" * Page 1016, column 1, line 27 - page 1017, column 2, line 22; figures 1;4 * | 1 | |

TECHNICAL FIELDS SEARCHED (Int. Cl.4)

G 01 R 23/00
G 06 F 15/00

--- -/-

The present search report has been drawn up for all claims

| Place of search | Date of completion of the search | Examiner |
|---|---|---|
| THE HAGUE | 05-08-1987 | TRELEVEN C. |

## DOCUMENTS CONSIDERED TO BE RELEVANT

Page 2

| Category | Citation of document with indication, where appropriate, of relevant passages | Relevant to claim | CLASSIFICATION OF THE APPLICATION (Int. Cl.4) |
|---|---|---|---|
| A | IEEE TRANSACTIONS ON AUDIO AND ELECTROACOUSTICS, vol. AU-21, no. 1, February 1973, pages 5-16, New York, US; B. GOLD et al.: "Parallelism in fast fourier transform hardware" * Page 7, column 2, line 9 - page 8, column 1, line 8; page 13, column 1, line 1 - page 15, column 1, line 12; figure 2 * | 1 | |
| A | ELECTRONIC DESIGN'S TELECOM DESIGN 1980, a conference for telecommunication systems designers, 1980, pages 154-186, Laurence Altman; G. EDWARDS et al.: "Spectrum analysis using the ami S2814a fast fourier transformer" * Page 157, last paragraph - page 160, line 7; figures 2-5 * | 3-4 | TECHNICAL FIELDS SEARCHED (Int. Cl.4) |
| A | US-A-4 054 785 (LEHMANN) * Column 19, lines 24-61; figure 9 * | 2,5 | |
| | --- -/- | | |

The present search report has been drawn up for all claims

| Place of search | Date of completion of the search | Examiner |
|---|---|---|
| THE HAGUE | 05-08-1987 | TRELEVEN C. |

| | DOCUMENTS CONSIDERED TO BE RELEVANT | | Page  3 | |
|---|---|---|---|---|
| **Category** | **Citation of document with indication, where appropriate, of relevant passages** | **Relevant to claim** | **CLASSIFICATION OF THE APPLICATION (Int. Cl.4)** | |
| A | IEEE TRANSACTIONS ON ACOUSTICS AND SIGNAL PROCESSING, vol. ASSP-34, no. 2, April 1986, pages 285-295, IEEE, New York, US; P. DUHAMEL: "Implementation of "Split-radix" FFT algorithms for complex, real, and real-symmetric data" <br> * Page 285, column 1,  line  1  - page 287, column 2, line 11; figure 1 * <br><br> ----- | 1-4 | |
| | | | **TECHNICAL FIELDS SEARCHED (Int. Cl.4)** |

The present search report has been drawn up for all claims

| Place of search | Date of completion of the search | Examiner |
|---|---|---|
| THE HAGUE | 05-08-1987 | TRELEVEN C. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document